# EUROPEAN PATENT SPECIFICATION

(11) **EP 3 340 292 B1**
(45) Date of publication and mention of the grant of the patent: **09.02.2022**
(21) Application number: 16206002.4
(22) Date of filing: 21.12.2016
(51) Int. Cl.: H01L 23/367, H01L 23/473, H01L 23/40

(54) **HEAT SINK, POWER ELECTRONICS UNIT COMPRISING THE HEAT SINK AND METHOD FOR ASSEMBLING THE POWER ELECTRONICS UNIT**
KÜHLKÖRPER, LEISTUNGSELEKTRONIK MIT DEM KÜHLKÖRPER UND VERFAHREN ZUR MONTAGE DER LEISTUNGSELEKTRONIKEINHEIT
DISSIPATEUR THERMIQUE, MODULE ÉLECTRONIQUE DE PUISSANCE COMPRENANT LE DISSIPATEUR THERMIQUE ET PROCÉDÉ D'ASSEMBLAGE DE MODULE ÉLECTRONIQUE DE PUISSANCE

(43) Date of publication of application: 27.06.2018
(73) Proprietor: Valeo Siemens eAutomotive Germany GmbH, 91056 Erlangen (DE)
(72) Inventor: KLAPPACH, Ullus, 35440 LINDEN (DE)
(74) Representative: Dr. Gassner & Partner mbB

(56) References cited:
- EP-A2- 2 101 402
- JP-A- 2004 153 034
- JP-A- 2005 142 520
- JP-A- 2010 109 016
- JP-A- 2015 231 042
- US-A1- 2009 289 351

## Description

The invention relates to a heat sink, intended to be integrated into a power electronics unit, comprising a cooling system.

The invention further concerns a power electronics unit comprising such heat sink and electronic components, and a method for assembling such power electronics unit.

EP 2 101 402 A2 discloses a power electronics unit comprising a channel case in which a cooling water channel is formed. Semiconductor modules with heat dissipation surfaces are cooled by cooling water flowing through the cooling water channel.

In JP 2010 109016 A a cooler is proposed, comprising a case having an upward outer projection with inclined surfaces on which semiconductor power elements are arranged. In addition, the case has an inner projection. A pipe for a coolant extends between the outer and the inner projection.

JP 2005 142520 A discloses a power module including a plurality of heat-generating elements and heatsinks for dissipating heat. Each heat sink has a plurality of faces which are not on the same plane.

Usually, a power electronics unit comprises power electronic components housed into die casted aluminum part. In operation of the power electronics unit, the power electronic components heat a lot, and thus need to be cooled.

Housing wherein the power electronic components are packed into bottom and lid architectures are known. The power loss bringers are contacted to a cooling channel which is closed with sealing at all external interfaces, for instance with water nozzles and electrical connectors.

Moreover, such power electronics unit needs to take into consideration safety rules, high voltage and high current path, isolation paths and electro-magnetic compatibility rules. These constraints impact the mechanical architecture, the system design, the weight, the complexity of the assembly and the cost of the power electronics unit.

However, in such power electronics unit, problems concerning the complexity of the housing parts and of the assembly, the management of the tolerance of the different components, the interconnection of the inner parts of the housing and the weight of the system appear.

Hence, there is a need for a cooling system intended to be integrated into a power electronics unit which allows cooling the electronics components and which is easy to assemble, smaller and lighter than the heat sink according to the prior art.

One object of the invention is to provide such heat sink.

To this end, the invention proposes a heat sink, intended to be integrated into a power electronics unit, the heat sink comprising a cooling system having:
a first portion having at least two parallel surfaces defining a first cooling channel of the cooling system, and
a second portion defining a second cooling channel of the cooling system having at least two parallel surfaces,
wherein each surface comprising a receiving area configured to receive an electronic component, and the at least two parallel surfaces of the first portion being transverse to the at least two parallel surfaces of the second portion.

Advantageously, the heat sink according to the invention is less complex, more reliable, lighter and less expensive than the heat sinks according to the prior art.

Moreover, the heat sink according to the invention allows a better dissipation of the heat of the first and second electronic components due to closer thermal connection between the electronic components and the cooling system of the heat sink.

Additionally, the heat sink according to the invention allows having less sealing and less critical tolerance relative to the design than the heat sinks according to the prior art.

According to embodiments, the heat sink according to the invention may further comprise one or several of the following features according to any possible combination:
- the surfaces of the first portion are perpendicular to the surfaces of the second portion; and/or
- the first and second portions are arranged so that the heat sink has a general X-shape form; and/or
- the first and second portions are arranged so that the heat sink has a general T-shape form; and/or
- the first and second portions are arranged so that the heat sink has a general L-shape form; and/or
- each receiving area comprises an elastic element configured to maintain the electronic component on the cooling system, notably pressing the electronic component against said receiving area; and/or
- the elastic element is a spring clip; and/or
- the cooling system comprises an inlet port and an outlet port, a coolant flowing inside the cooling system from the inlet port to the outlet port; and/or
- the first portion comprises a third surface joining the two parallel surfaces of the first portion, the first portion defining the first cooling channel of the cooling system, and wherein the second portion comprises a fourth surface joining the two parallel surfaces of the second portion, the second portion defining the second cooling channel of the cooling system; and/or
- the first and second cooling channels are joined one to the other; and/or
- the heat sink is made of metal, for example aluminum.

The invention further relates to a power electronics unit comprising a heat sink according to the invention and at least four electronic components, each receiving area of the cooling system of the heat sink receiving an electronic component.

Advantageously, the power electronics unit according to the invention is easy to assemble, less complex, more reliable, lighter and less expensive than the power electronics units according to the prior art.

Plus, the power electronics unit according to the invention allows a better dissipation of the heat of the electronic components due to closer thermal connection between the electronic components and the heat sink.

Furthermore, the power electronics unit according to the invention allows having less components stress than the power electronics units according to the prior art.

Additionally, the power electronics unit according to the invention allows increasing the packaging density and the power density compared to the power electronics units according to the prior art. More precisely, the power electronics unit according to the invention allows having simplified interconnections between the electronic components.

According to embodiments, the power electronics unit according to the invention may further comprise the following feature:
- the electronic component is a power module.

The invention further relates to a method for assembling a power electronics unit, the power electronics unit comprising a plurality of electronic components and a first and a second heat sinks according to the invention, each cooling system comprising an inlet port and an outlet port configured to receive a coolant flowing inside the cooling system from the inlet port to the outlet port, the method comprising:
- a step during which the plurality of electronic components is provided,
- a step during which the first and second heat sinks are provided,
- a coupling step during which the outlet port of the first heat sink is coupled to the inlet port of the second heat sink to receive a coolant flowing inside the cooling systems of the first and second heat sinks from the inlet port of the first heat sink to the outlet port of the second heat sink, and
- a receiving step, during which at least an electronic component of the plurality of electronic components is received on each receiving area of the cooling system of the first and second heat sinks.

Advantageously, the method for assembling a power electronics unit according to the invention allows having a power electronics unit easy to assemble, less complex, more reliable, lighter and less expensive than the power electronics unit according to the prior art.

Moreover, the method for assembling a power electronics unit according to the invention allows having a power electronics unit having a scalable mechanical design approach.

Other characteristics and advantages of the invention will become more apparent from the claims and from the following description of some embodiments given by way of example without limitation with reference to the drawings, in which:
- Figures 1 to 4 represent embodiments of a heat sink according to the invention,
- Figures 5 and 6 represent embodiments of a power electronics unit according to the invention, and
- Figure 7 is a flowchart of the different steps of a method for assembling a power electronics unit according to the invention.

Elements in the figures are illustrated for simplicity and clarity and have not necessarily been drawn to scale. For example, the dimensions of some of the elements in the figure may be exaggerated relative to other elements to help improve the understanding of the embodiments of the present invention.

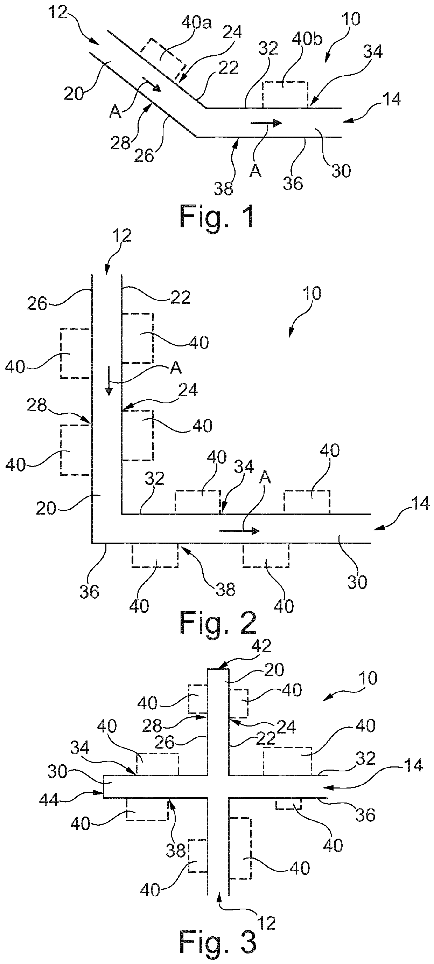

The present invention concerns a heat sink intended to be integrated into a power electronics unit. The power electronics unit may be a converter such as for instance a DC/DC converter, an AC/DC converter or a on-board charger for charging a battery of a vehicle from an outer electric grid. Embodiments of a heat sink according to the invention are represented in figures 1 to 4.

The heat sink 10 comprises a cooling system having a first portion 20 and a second portion 30.

The first portion 20 has at least one surface 22 comprising a receiving area 24 configured to receive a first electronic component 40a.

The second portion 30 has at least one surface 32 comprising a receiving area 34 configured to receive a second electronic component 40b.

Each receiving area 24, 34 may be configured to receive a plurality of electronic components 40. The electronic components may be power modules.

The surface 22 of the first portion 20 is transverse to the surface 32 of the second portion 30. For instance, as illustrated in figures 2 to 4, the surface 22 of the first portion 20 is perpendicular to the surface 32 of the second portion 30.

Advantageously, such heat sink allows a better dissipation of the heat of the first and second electronic components due to closer thermal connection between the first and second electronic components and the cooling system of the heat sink.

As represented in figures 1 to 4, the first portion 20 may have at least two parallel surfaces 22, 26 and the second portion 30 may have at least two parallel surfaces 32, 36. The surfaces 26, 36 of the first and second portions 20, 30 may have a receiving area 28, 38.

In other words, each surface 22, 26, 32, 36 of the first and second portions 20, 30 may comprise a receiving area 24, 28, 34, 38 configured to receive an electronic component 40.

The surfaces 22, 26 of the first portion 20 being transverse to the surfaces 32, 36 of the second portion 30. For example, the surfaces 22, 26 of the first portion 20 may be perpendicular to the surfaces 32, 36 of the second portion 30, as illustrated in figures 2 to 4.

The heat sink 10 may be made of metal, for example aluminum.

As represented in figures 1 to 4, the cooling system may comprise an inlet port 12 and an outlet port 14, a coolant flowing inside the cooling system from the inlet port 12 to the outlet port 14. For instance, the path of the coolant in the cooling system is represented by arrows A in figures 1 and 2.

The cooling system may comprise a plurality of inlet and outlet ports.

As illustrated in figure 2, the first and second portions 20, 30 may be arranged so that the heat sink 10 has a general L-shape form. In particular, the heat sink 10 may comprise a cooling system having a first portion 20 having two surfaces 22, 26 and a second portion 30 having two surfaces 32, 36.

As illustrated in figure 3, the first and second portions 20, 30 may be arranged so that the heat sink 10 has a general X-shape form. In particular, the heat sink 10 may comprise a cooling system having a first portion 20 having four surfaces 22, 26 and a second portion 30 having four surfaces 32, 36.

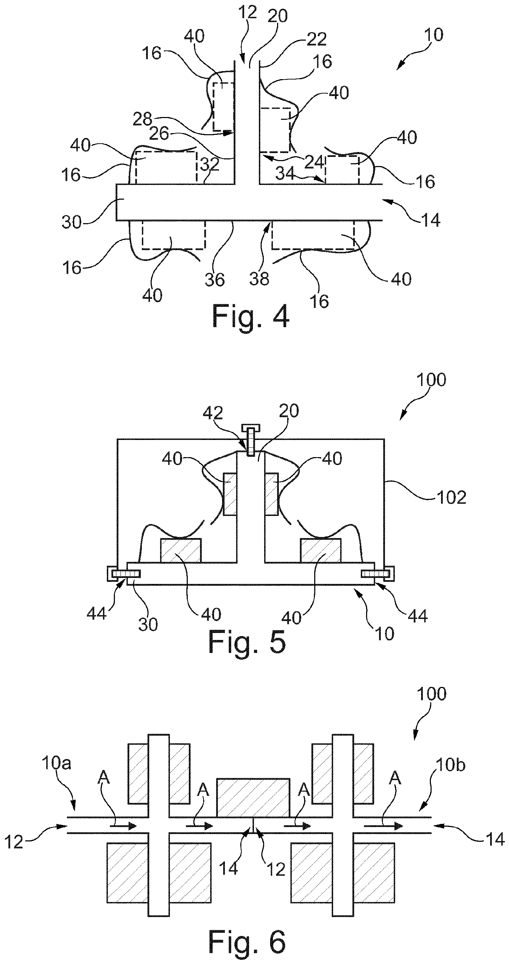

As illustrated in figure 4, the first and second portions 20, 30 may be arranged so that the heat sink 10 has a general T-shape form. In particular, the heat sink 10 may comprise a cooling system having a first portion 20 having two surfaces 22, 26 and a second portion 30 having three surfaces 32, 36.

As represented in figures 2 to 4, the surfaces 22, 26 of the first portion 20 may be parallel and the surfaces 32, 36 of the second portion 30 may be parallel. Moreover, the surfaces 22, 26 of the first portion 20 may be perpendicular to the surfaces 32, 36 of the second portion 30.

Each surface 22, 26, 32, 36 may respectively comprise a receiving area 24, 28, 34, 38 configured to receive electronic components 40.

Each receiving area 24, 28, 34, 38 may receive one or more electronic components 40. For instance, each receiving area 24, 28, 34, 38 in figure 2 receive two electronic components 40 and each receiving area 24, 28, 34, 38 in figure 3 receives one electronic component 40.

Advantageously, the heat sink according to the invention is compact, due to the receiving areas on each surface.

As represented in figure 4, each receiving area 24, 28, 34, 38 may comprise an elastic element 16 configured to maintain an electronic component 40 on the cooling system, notably pressing the electronic component 40 against said receiving area 24, 28, 34, 38. The elastic element 16 may be a spring clip.

As represented in figure 3, the first portion 20 may comprise a third surface 42 joining two parallel surfaces 22, 26 of the first portion 20 so that the first portion 20 defines a first cooling channel of the cooling system. The second portion 30 may comprise a fourth surface 44 joining two parallel surfaces 32, 36 of the second portion 30 so that the second portion 30 defines a second cooling channel of the cooling system.

The first and second cooling channels may be joined one to the other, as represented in figures 1 to 4.

The cooling system of heat sink may comprise fins in order to manage multidirectional coolant flow.

The invention further concerns a power electronics unit comprising a heat sink as described previously. An embodiment of a power electronics unit according to the invention is represented in figure 5.

The power electronics unit 100 comprises a heat sink 10 and at least two electronic components 40, for instance four electronic components 40 in figure 5.

As illustrated in figure 5, the power electronics unit 100 may further comprise a cover 102 fixed to the heat sink 10 on the third surface 42 of the first portion 20 and/or on the fourth surface 44 of the second portion 30, for instance to one third surface 42 of the first portion 20 and to two fourth surfaces 44 of the second portion 30.

The cover 102 may be screwed to the heat sink 10, as represented in figure 5.

The power electronics unit 100 may comprise a first heat sink 10a and a second heat sink 10b as described previously, as represented in figure 6.

Each cooling system may comprise an inlet port 12 and an outlet port 14 configured to receive a coolant flowing inside the cooling system from the inlet port 12 to the outlet port 14.

In particular, the outlet port 14 of the first heat sink 10a may be coupled to the inlet port 12 of the second heat sink 10b. The power electronics unit 100 is configured so that the coolant flows inside the cooling systems of the first and second heat sinks 10a, 10b from the inlet port 12 of the first heat sink 10a to the outlet port 14 of the second heat sink 10b. For instance, the path of the coolant in the cooling systems is represented by arrows A in figure 6.

As illustrated in figure 6, the heat sinks 10a, 10b have the same X-shape form. Of course, a power electronics unit may comprise heat sinks having different forms.

Advantageously, additional heat sinks may easily be added to the power electronics unit in order to add further surfaces comprising receiving areas and further cooling channels.

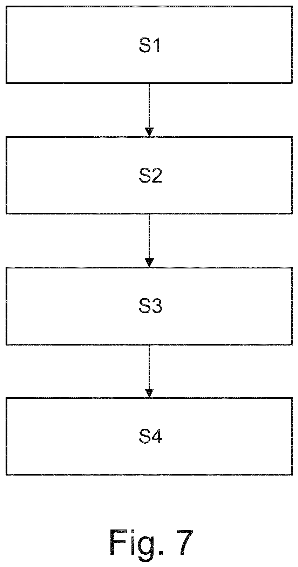

The invention further concerns a method for assembling a power electronics unit as described previously. Such method is illustrated in figure 7.

The method comprises an electronic components providing step S1, during which a plurality of electronic components is provided.

The method comprises a heat sinks providing step S2, during which a first heat sink and a second heat sink as described previously are provided.

The method comprises a coupling step S3, during which the outlet port of the first heat sink is coupled to the inlet port of the second heat sink to receive a coolant flowing inside the cooling systems of the first and second heat sinks from the inlet port of the first heat sink to the outlet port of the second heat sink.

The method comprises a receiving step S4, during which at least an electronic component of the plurality of electronic components is received on each receiving area of the cooling system of the first and second heat sinks.

Advantageously, such method allows having a power electronics unit having a scalable mechanical design approach.

The method may further comprise a cover providing step, during which a cover is provided.

The method may further comprise a fixing step, during which the cover is fixed to the first and second heat sinks, for instance by screwing.

The invention has been described above with the aid of embodiments without limitation of the general inventive concept. Moreover, the embodiments of the invention may be combined without any restriction.

Many further modifications and variations will suggest themselves to those skilled in the art upon making reference to the foregoing illustrative embodiments, which are given by way of example only and which are not intended to limit the scope of the invention, that being determined solely by the appended claims.

In the claims, the word "comprising" does not exclude other elements or steps, and the indefinite article "a" or "an" does not exclude a plurality. The mere fact that different features are recited in mutually different dependent claims does not indicate that a combination of these features cannot be advantageously used. Any reference signs in the claims should not be construed as limiting the scope of the invention.

## Claims

1. Heat sink (10), intended to be integrated into a power electronics unit, the heat sink (10) comprising a cooling system having:
a first portion (20) having at least two parallel surfaces (22, 26) defining a first cooling channel of the cooling system, and
a second portion (30) defining a second cooling channel of the cooling system having at least two parallel surfaces (32, 36),
wherein each surface (22, 26, 32, 36) comprising a receiving area (24, 28, 34, 38) configured to receive an electronic component (40, 40a, 40b), and the at least two parallel surfaces (22, 26) of the first portion (20) being transverse to the at least two parallel surfaces (32, 36) of the second portion (30).

2. Heat sink according to claim 1, wherein the surfaces (22, 26) of the first portion (20) are perpendicular to the surfaces (32, 36) of the second portion (30).

3. Heat sink according to claim 2, wherein the first and second portions (20, 30) are arranged so that the heat sink (10) has a general X-shape form.

4. Heat sink according to claim 2, wherein the first and second portions (20, 30) are arranged so that the heat sink (10) has a general T-shape form.

5. Heat sink according to claim 2, wherein the first and second portions (20, 30) are arranged so that the heat sink (10) has a general L-shape form.

6. Heat sink according to any of the preceding claims, wherein each receiving area (24, 28, 34, 38) comprises an elastic element (16) configured to maintain the electronic component (40) on the cooling system, notably pressing the electronic component (40) against said receiving area (24, 28, 34, 38).

7. Heat sink according to claim 6, wherein the elastic element (16) is a spring clip.

8. Heat sink according to any of the preceding claims, wherein the cooling system comprises an inlet port (12) and an outlet port (14), a coolant flowing inside the cooling system from the inlet port (12) to the outlet port (14).

9. Heat sink according to claim 8, wherein the first portion (20) comprises a third surface (42) joining the two parallel surfaces (22, 26) of the first portion (20), and wherein the second portion (30) comprises a fourth surface (44) joining the two parallel surfaces (32, 36) of the second portion (30).

10. Heat sink according to claim 9, wherein the first and second cooling channels are joined one to the other.

11. Power electronics unit comprising a heat sink according to any of claims 1 to 10 and at least four electronic components (40), each receiving area (24, 28, 34, 38) of the cooling system of the heat sink (10) receiving an electronic component (40).

12. Method for assembling a power electronics unit, the power electronics unit comprising a plurality of electronic components and a first and a second heat sink according to any of claims 1 to 10, each cooling system comprising an inlet port and an outlet port configured to receive a coolant flowing inside the cooling system from the inlet port to the outlet port, the method comprising:
- a step during which the plurality of electronic components is provided,
- a step during which the first and second heat sinks are provided,
- a coupling step, during which the outlet port of the first heat sink is coupled to the inlet port of the second heat sink to receive a coolant flowing inside the cooling systems of the first and second heat sinks from the inlet port of the first heat sink to the outlet port of the second heat sink, and
- a receiving step, during which at least an electronic component of the plurality of electronic components is received on each receiving area of the cooling system of the first and second heat sinks.

## Patentansprüche

1. Kühlkörper (10), der dazu bestimmt ist, in eine Leistungselektronikeinheit integriert zu werden, wobei der Kühlkörper (10) ein Kühlsystem aufweist, umfassend:
einen ersten Teil (20) mit mindestens zwei parallelen Flächen (22, 26), die einen ersten Kühlkanal des Kühlsystems bilden, und
einen zweiten Teil (30), der einen zweiten Kühlkanal des Kühlsystems mit mindestens zwei parallelen Flächen (32, 36) bildet,
wobei jede Fläche (22, 26, 32, 36) einen Aufnahmebereich (24, 28, 34, 38) umfasst, der zur Aufnahme eines elektronischen Bauteils (40, 40a, 40b) konfiguriert ist, und wobei die mindestens zwei parallelen Flächen (22, 26) des ersten Teils (20) quer zu den mindestens zwei parallelen Flächen (32, 36) des zweiten Teils (30) verlaufen.

2. Kühlkörper nach Anspruch 1, wobei die Oberflächen (22, 26) des ersten Teils (20) senkrecht zu den Oberflächen (32, 36) des zweiten Teils (30) stehen.

3. Kühlkörper nach Anspruch 2, wobei der erste und der zweite Teil (20, 30) so angeordnet sind, dass der Kühlkörper (10) im Allgemeinen eine X-Form aufweist.

4. Kühlkörper nach Anspruch 2, wobei der erste und der zweite Teil (20, 30) so angeordnet sind, dass der Kühlkörper (10) im Allgemeinen eine T-Form aufweist.

5. Kühlkörper nach Anspruch 2, wobei der erste und der zweite Teil (20, 30) so angeordnet sind, dass der Kühlkörper (10) im Allgemeinen eine L-Form aufweist.

6. Kühlkörper nach einem der vorhergehenden Ansprüche, wobei jeder Aufnahmebereich (24, 28, 34, 38) ein elastisches Element (16) umfasst, das so gestaltet ist, dass es das elektronische Bauteil (40) auf dem Kühlsystem hält und insbesondere das elektronische Bauteil (40) gegen den Aufnahmebereich (24, 28, 34, 38) drückt.

7. Kühlkörper nach Anspruch 6, wobei das elastische Element (16) eine Federklammer ist.

8. Kühlkörper nach einem der vorhergehenden Ansprüche, wobei das Kühlsystem eine Einlassöffnung (12) und eine Auslassöffnung (14) umfasst, wobei ein Kühlmittel innerhalb des Kühlsystems von der Einlassöffnung (12) zur Auslassöffnung (14) strömt.

9. Kühlkörper nach Anspruch 8, wobei der erste Teil (20) eine dritte Fläche (42) aufweist, die die beiden parallelen Flächen (22, 26) des ersten Teils (20) verbindet, und wobei der zweite Teil (30) eine vierte Fläche (44) aufweist, die die beiden parallelen Flächen (32, 36) des zweiten Teils (30) verbindet.

10. Kühlkörper nach Anspruch 9, wobei der erste und der zweite Kühlkanal miteinander verbunden sind.

11. Leistungselektronikeinheit mit einem Kühlkörper nach einem der Ansprüche 1 bis 10 und mindestens vier elektronischen Bauteilen (40), wobei jeder Aufnahmebereich (24, 28, 34, 38) des Kühlsystems des Kühlkörpers (10) ein elektronisches Bauteil (40) aufnimmt.

12. Verfahren zum Zusammenbau einer Leistungselektronikeinheit, wobei die Leistungselektronikeinheit eine Mehrzahl elektronischer Komponenten und einen ersten und einen zweiten Kühlkörper nach einem der Ansprüche 1 bis 10 umfasst, wobei jedes Kühlsystem eine Einlassöffnung und eine Auslassöffnung umfasst, die so konfiguriert sind, dass sie ein Kühlmittel aufnehmen, das innerhalb des Kühlsystems von der Einlassöffnung zur Auslassöffnung fließt, wobei das Verfahren umfasst:
- einen Schritt, in dem die mehreren elektronischen Bauteile bereitgestellt werden,
- einen Schritt, in dem der erste und der zweite Kühlkörper bereitgestellt werden,
- einen Kopplungsschritt, bei dem die Auslassöffnung des ersten Kühlkörpers mit der Einlassöffnung des zweiten Kühlkörpers gekoppelt wird, um ein Kühlmittel aufzunehmen, das innerhalb der Kühlsysteme der ersten und zweiten Kühlkörper von der Einlassöffnung des ersten Kühlkörpers zur Auslassöffnung des zweiten Kühlkörpers fließt, und
- einen Aufnahmeschritt, bei dem mindestens ein elektronisches Bauteil der mehreren elektronischen Bauteile auf jedem Aufnahmebereich des Kühlsystems der ersten und zweiten Kühlkörper aufgenommen wird.

## Revendications

1. Dissipateur thermique (10) destiné à être intégré dans une unité d'électronique de puissance, le dissipateur thermique (10) comprenant un système de refroidissement ayant :
une première partie (20) ayant au moins deux surfaces parallèles (22, 26) définissant un premier canal de refroidissement du système de refroidissement, et
une deuxième partie (30) définissant un deuxième canal de refroidissement du système de refroidissement ayant au moins deux surfaces parallèles (32, 36),
en ce que chaque surface (22, 26, 32, 36) comprenant une zone de réception (24, 28, 34, 38) conçue pour recevoir un composant électronique (40, 40a, 40b), et au moins les deux surfaces parallèles (22, 26) de la première partie (20) étant transversales par rapport au moins aux deux surfaces parallèles (32, 36) de la deuxième partie (30).

2. Dissipateur thermique selon la revendication 1, en ce que les surfaces (22, 26) de la première partie (20) sont perpendiculaires aux surfaces (32, 36) de la deuxième partie (30).

3. Dissipateur thermique selon la revendication 2, en ce que les première et deuxième parties (20, 30) sont disposées de telle sorte que le dissipateur thermique (10) a une forme générale en X.

4. Dissipateur thermique selon la revendication 2, en ce que les première et deuxième parties (20, 30) sont disposées de telle sorte que le dissipateur thermique (10) a une forme générale en T.

5. Dissipateur thermique selon la revendication 2, en ce que les première et deuxième parties (20, 30) sont disposées de telle sorte que le dissipateur thermique (10) a une forme générale en L.

6. Dissipateur thermique selon l'une des revendications précédentes, en ce que chaque zone de réception (24, 28, 34, 38) comprend un élément élastique (16) conçu pour maintenir le composant électronique (40) sur le système de refroidissement, notamment en pressant le composant électronique (40) contre ladite zone de réception (24, 28, 34, 38).

7. Dissipateur thermique selon la revendication 6, en ce que l'élément élastique (16) est une pince à ressort.

8. Dissipateur thermique selon l'une des revendications précédentes, en ce que le système de refroidissement comprend un port d'entrée (12) et un port de sortie (14), un fluide de refroidissement circulant à l'intérieur du système de refroidissement du port d'entrée (12) au port de sortie (14).

9. Dissipateur thermique selon la revendication 8, en ce que la première partie (20) comprend une troisième surface (42) reliant les deux surfaces parallèles (22, 26) de la première partie (20), et en ce que la deuxième partie (30) comprend une quatrième surface (44) reliant les deux surfaces parallèles (32, 36) de la deuxième partie (30).

10. Dissipateur thermique selon la revendication 9, en ce que les premier et deuxième canaux de refroidissement sont reliés l'un à l'autre.

11. Unité d'électronique de puissance comprenant un dissipateur thermique selon l'une des revendications 1 à 10 et au moins quatre composants électroniques (40), chaque zone de réception (24, 28, 34, 38) du système de refroidissement du dissipateur thermique (10) recevant un composant électronique (40).

12. Procédé d'assemblage d'une unité d'électronique de puissance, l'unité d'électronique de puissance comprenant une pluralité de composants électroniques et un premier et un deuxième dissipateur thermique selon l'une des revendications 1 à 10, chaque système de refroidissement comprenant un port d'entrée et un port de sortie conçus pour recevoir un fluide de refroidissement circulant à l'intérieur du système de refroidissement du port d'entrée au port de sortie, le procédé comprenant :
- une étape au cours de laquelle la pluralité de composants électronique est fournie,
- une étape au cours de laquelle les premier et deuxième dissipateurs thermiques sont fournis,
- une étape de couplage au cours de laquelle le port de sortie du premier dissipateur thermique est couplé au port d'entrée du deuxième dissipateur thermique pour recevoir un fluide de refroidissement circulant à l'intérieur des systèmes de refroidissement des premier et deuxième dissipateurs thermiques du port d'entrée du premier dissipateur thermique au port de sortie du deuxième dissipateur thermique, et
- une étape de réception au cours de laquelle au moins un composant électronique de la pluralité de composants électroniques est reçu sur chaque zone de réception du système de refroidissement des premier et deuxième dissipateurs thermiques.
